(19) Europäisches Patentamt
European Patent Office
Office européen des brevets

(11) Publication number: **0 054 736**
**B1**

(12) **EUROPEAN PATENT SPECIFICATION**

(45) Date of publication of patent specification: **22.05.85**

(51) Int. Cl.⁴: **G 03 F 1/00**

(21) Application number: **81109440.8**

(22) Date of filing: **30.10.81**

(54) Photomask and photomask blank.

(30) Priority: 22.12.80 JP 180409/80
31.03.81 JP 47922/81
31.03.81 JP 47923/81

(43) Date of publication of application:
30.06.82 Bulletin 82/26

(45) Publication of the grant of the patent:
22.05.85 Bulletin 85/21

(84) Designated Contracting States:
CH DE FR LI

(56) References cited:
EP-A-0 049 799

IBM TECHNICAL DISCLOSURE BULLETIN, vol.
19, no. 8, January 1977, New York, USA M.D.
APPOLONIA et al.: "Chemical and wear
resistant material" Page 3026
JOURNAL OF VACUUM SCIENCE
TECHNOLOGY, vol. 16, no. 6,
November/December 1979, pages 1962-1964,
American Institute of Physics, New York, USA
L. CSEPREGI et al.: "Fabrication of silicon
oxynitride masks for x-ray lithography"

(73) Proprietor: DAI NIPPON INSATSU KABUSHIKI
KAISHA
1-1, Kaga-Cho 1-Chome Ichigaya Shinjuku-Ku
Tokyo 162 (JP)

(72) Inventor: Kaneki, Satoru
11-202, Sayama Griin Haitsu 213, Sasai
Sayama-shi Saitama-ken (JP)
Inventor: Kikuchi, Yuzi
7-6-101, Ciyoda 4-Chome
Sakado-shi Saitama-ken (JP)
Inventor: Sasaki, Yoji
17-10, Tokura 3-Chome
Kokubunji-shi Tokyo-To (JP)

(74) Representative: Patentanwälte Dipl.-Ing. Klaus
Behn Dipl.-Phys. Robert Münzhuber
Widenmayerstrasse 6/IV
D-8000 München 22 (DE)

Courier Press, Leamington Spa, England.

## Description

This invention relates to photomasks and photomask blanks for use in the production of semiconductors, integrated circuits (IC), large-scale integrated circuits (LSI), and like electronic components.

Photomasks are original plates for printing very minute circuit images or others repeatedly with good precision on wafers of semiconductors, etc. In the prior art, there have been known emulsion masks using inexpensive photographic plates having high resolving power, and also hard masks of excellent durability, including chromium masks, tantalum masks, silicon masks and others.

In general, for high precision purposes, hard masks of excellent resolving power have been employed. Among them, mono-layer chromium masks and tantalum masks have high surface reflectance and therefore repetitive reflection is liable to be caused between masks and wafers. For the purpose of avoiding such repetitive reflection, use is practically made of one-side low-reflection masks in which there is provided a reflection preventive layer of chromium oxide or tantalum oxide on one side and further of both-side low-reflection masks, for enabling actuation of auto mask aligners, in which a similar reflection preventive layer is also provided on the opposite side.

While these multi-layer masks have the advantages of affording a broad exposure latitude in pattern printing on wafers and of enabling actuation of an auto aligner such as that of Casper Co.'s type, they have a drawback in that it is difficult to form images of good quality and durability on these masks, themselves, as compared with mono-layer type chromium or tantalum masks.

More specifically, this problem is due to the difference in etching speed between the layer of chromium or tantalum (hereinafter sometimes simply referred to as "metal" unless either one of chromium and tantalum is specifically meant) and the layer of chromium or tantalum oxide (hereinafter sometimes simply referred to as "oxide" unless either one of chromium oxide and tantalum oxide is specifically meant) laminated on the upper or lower surface of the metal layer when the masking layer in the multi-layer structure is to be patterned by etching according to the well-known photolithography process. Usually, the etching speed in the oxide layer is slower than by several times than in the metal layer. Therefore, since the etching speed is faster in the lower metal layer than in the upper metal oxide layer, the undercut quantity of the metal layer is greater, thereby forming a visor of the oxide layer at peripheral portions of images.

On the other hand, because the etching speed varies greatly at an intermediary portion of the entire film, the film as a whole is prone to be unevenly etched, whereby the sharpness of image is impaired, and formation of edges like burrs or mouse nip is frequently caused. Formation of visors around patterns is a great problem because such visors protrude out of the pattern edges as films of some hundred angstroms in thickness, which are very brittle and readily fractured. Practically, fracture will occur in various washing procedures during fabrication or usage of masks or in contact with or peel-off from the resist surface during transfer of images, thereby causing edges like discontinuous burrs or mouse nip to be formed around the images.

The above phenomenon is in contradiction to use for an acceptable high precision transfer and is particularly incompatible with the purpose of producing high performance semiconductor devices such as V-LSI. On the other hand, formation of visors around mask patterns also means that the optical concentration gradient of the image edges is microscopically gentle, whereby dimensional accuracy at the time of transfer is readily affected by exposure conditions to cause lowering of precision. Furthermore, the difference in etching speed between the metal layer and the oxide layer may sometimes cause dimensional shift where the multi-layer masking film is subject to overetching.

As a method generally practiced for overcoming these problems, metal films and oxide films are formed according to the methods which are different from each other. For example, for a chromium mask, a chromium film of the lower layer is formed by sputtering while a chromium oxide film of the upper layer is deposited by vacuum evaporation. This is based on the principle that the chromium oxide layer obtained by vacuum evaporation can be etched faster than that formed by sputtering, its etching speed nearer to the etching speed of the chromium layer formed by sputtering. The reason why there is such a difference in etching speed between the methods has not yet been clarified, but it is presumably because sputtering can produce films which are generally more dense as compared with those formed by vacuum evaporation, which are sparse and lower in degree of oxidation.

If, instead of resorting to this method, the chromium and chromium oxide layers are laminated by only the ordinary sputtering method or vacuum evaporation method, visors or burrs will be formed since the etching speed of the chromium oxide layer is relatively higher than that of the chromium layer as stated above. A critical drawback resulting from a combination of the sputtering method and the vacuum evaporation method is a remarkably low productivity due to the steps of first forming a film by sputtering, thereafter taking the product once out of the vacuum, and again performing vapor deposition of a film in a vacuum evaporator.

Further, with respect to quality, also, a chromium oxide film is formed again on the chromium film which has been once exposed to the atmosphere, whereby the chromium oxide film obtained has poor reproducibility of the film properties. Another disadvantage is that there is a great probability of dust being drawn in to adhere on the chromium film when returning from vacuum to atmospheric pressure in the apparatus after formation of the chromium film of the lower layer, whereby pinholes are liable to be formed in the chromium oxide film of the upper layer.

If an intermediate washing step is introduced for avoiding this probability, the number of steps will be increased, and the quality of the product may be unstable, varying with such washing operations. Furthermore, when a chromium oxide film is formed by sputtering, it is possible to form a chromium oxide film with lower degree of oxidation by controlling the partial pressure in the atmosphere, the film having an etching speed similar to that of a chromium film.

However, it is extremely difficult to control the sputtering conditions for formation of this film in an intermediary oxidized state, and the reproducibility is poor. Further, if the degree of oxidation is too low, the refractory index of the film is increased to impair the effect of prevention of reflection as originally intended. The difficulty in controlling the formation of the above intermediarily oxidized film is further pronounced in the case of reactive vacuum evaporation.

The above difficulties are also encountered for the production of tantalum masks where the tantalum oxide layer is formed by sputtering, reactive sputtering or reactive vacuum evaporation. For the production of tantalum masks, the tantalum oxide layer may sometimes be produced by anodic oxidation. While the anode oxidation method makes possible uniform and bulk treatment for formation of an oxide film for a tantalum oxide layer, it is a wet process with the use of a chemical reagent and therefore must follow steps different from those of the dry process, such as sputtering employed for formation of a tantalum layer. Since this is a wet process, it entails complications in liquid handling with respect to impurities, foreign matters, particles, and the like, whereby defects are liable to be caused on the surface of a mask blank.

In order to eliminate the difference in etching speed, it may be considered possible to vary the quality of the oxide film by changing the liquid composition for the anodic oxidation, and the temperature and magnitude of current for the anodic oxidation and the sputtering in addition to the gaseous composition during the sputtering as described above. However, the range of such a variation is very narrow, and a drastic change in conditions may result in impairment of the basic properties such as durability and optical characteristics of the film, or in marked lowering of productivity.

In view of the above difficulties encountered in the metal-metal oxide multi-layer masks, it is a primary object of the invention to provide a chromium or tantalum multi-layer photomask with high precision and high durability, and also its blank.

We have carried out studies with the above object and consequently found that it is very effective for achievement of the above object to use a composite layer comprising the oxide and nitride of chromium or tantalum, in place of a chromium or tantalum oxide layer as a reflection protective layer, and to laminate it with a chromium or tantalum film. The present invention is based on this finding.

The photomask blank according to the present invention comprises a transparent substrate and a multi-layer masking film provided on the substrate. The multi-layer masking film comprises a layer of metal selected from the group consisting of chromium and tantalum and a composite layer of oxide and nitride of the metal laminated on the metal layer.

The photomask according to the invention is characterized in that the multi-layer masking film in the above photomask blank has been patternized.

The photomask blank according to the invention essentially eliminates the above described difficulties arising from the difference in etching speed between the metal masking layer and the low reflection layer, whereby photomasks with excellent performance can be produced.

The present invention is based in principle on the fact that, with respect to chromium or tantalum, the nitride film, contrary to the oxide film, has a higher etching speed than the metal film and on the fact that, by suitable variation of the ratios in the composition of the metal oxide and the metal nitride, it is possible to control the etching speed over a considerably wide range.

The composite film of the metal oxide and the metal nitride has chemical resistance and optical characteristics which are substantially the same as those of a conventionally used metal oxide film, yet being free of the problems as described above, and is capable of realizing images with excellent durability and high precision.

The nature, utility, and further features of this invention will be more clearly apparent from the following detailed desciption, beginning with a consideration of general aspects of the invention and concluding with specific examples of practice thereof, when read in conjunction with the accompanying drawing, briefly described below.

In the drawing:

Figs. 1a and 1b are schematic sectional views, with parts cut away, respectively showing examples of multilayer photomasks of the prior art;

Fig. 2 is a plan view of a multi-layer photomask of the prior art indicating shapes of edges of an image;

Figs. 3a and 3b are sectional views, similar to Figs. 1a and 1b, respectively showing examples of multi-layer photomask according to this invention; and

Figs. 4a and 4b are schematic sectional views, with parts cut away, respectively showing examples of multilayer photomask blanks according to the invention.

In addition to the definitions of the terms "metal" and "oxide" hereinbefore, the term "nitride" is herein intended to mean chromium nitride or tantalum nitride unless otherwise specified.

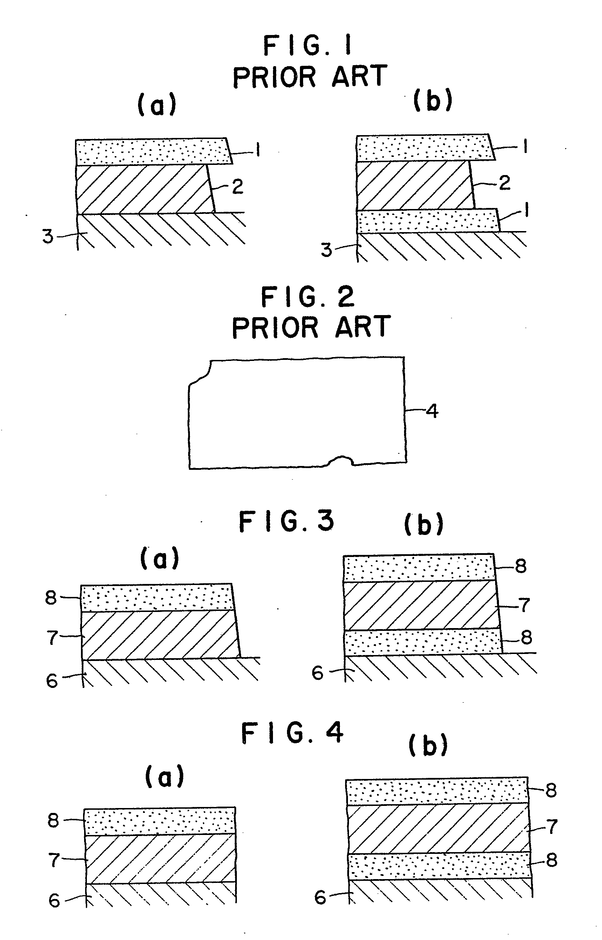

According to the one-side low-reflection metal mask and both-side low-reflection metal mask of the prior art, as shown in Figs. 1a and 1b, respectively, a metal layer 2 and an upper metal oxide layer 1 are formed without an intermediary lower metal oxide layer [as in Fig. 1a] or through an intermediary lower metal oxide layer [as in Fig. 1b] on a transparent substrate 3. The primary problem in low-reflection metal masks of the prior art was that the undercut quantity of the metal layer 2 is increased because of higher etching speed in the metal layer 2 than in the upper oxide layer 1 to form a projection like a visor of the oxide layer 1, which may result in fractures such as burrs or mouse nip on the flat image 4 as shown in Fig. 2.

Fig. 3a is a schematic view of the sectional structure of one embodiment of the one-side low-reflection metal mask according to the present invention. On a transparent substrate 6, which is made of soda lime glass, borosilicate glass, quartz glass, sapphire, or the like having surface smoothness, there is provided a metal film as a masking layer 7, of a thickness of generally 30 to 150 nm, preferably 50 to 100 nm, by a conventional method such as vacuum evaporation or sputtering, on which metal film is further provided, as a reflection preventive film 8, a composite film of metal oxide and metal nitride, of a thickness of generally 20 to 50 nm, preferably 20 to 40 nm. Thereafter patternization of the laminated films is carried out.

Fig. 3b shows a schematic view of one embodiment of a both-side low-reflection metal mask according to the present invention. On a transpratent substrate 6 similar to that described above, there is provided a composite film 8 of metal oxide and metal nitride, of a thickness of generally 20 to 50 nm, preferably 30 to 40 nm, and then a metal film 7 with thickness of 30 to 150 nm, preferably 40 to 100 nm, is formed on the composite film. Further, a composite film 8 of oxide and nitride similar to that described above is formed on the metal film 7. Thereafter, patternization of the laminated films is carried out.

The composition in the composite film, which may be different depending on the conditions for preparation of the film, may be expressed in terms of $M_xN_yO_z$ wherein M denotes chromium or tantalum, and the atomic ratio is suitably within the range of $x=1$, $y=0.1$—$0.3$ and $z=0.8$—$1.4$ for chromium and of $x=1$, $y=0.15$—$0.5$ and $z=1.0$—$2.5$ for tantalum. Practically, it is necessary to select optimum values for x, y and z so that the etching speed in each film will coincide with each other in conformity with the device and conditions for formation of the film.

This composite film can be prepared by a sputtering method wherein there is used a target with a composition of $M_xN_yO_z$ prepared by mixing the metal oxide and metal nitride in the form of powder in a suitable ratio and then by sintering; a reactive sputtering method wherein sputtering is performed in an atmosphere of a gas mixture of $N_2$ and $O_2$, with use of the metal as target; a vacuum evaporation method wherein $M_xN_yO_z$ is used as a source; or a reactive vacuum evaporation method wherein the metal is used as source in an atmosphere of a gas mixture of $N_2$ and $O_2$.

The existing state of metal oxide and metal nitride in the thus prepared composite film, while it has not yet been clarified in detail, seems to be a compound of higher order rather than a simple mixture or in a mixed state of a mixture with a compound of higher order. It is also possible to incorporate such a small amount of other elements in the composite film that they will not influence substantially the etching speed thereof.

In forming successively the metal film 7 and the composite film 8 on the transparent substrate 6, the source composition can be changed in a sputtering method or a vacuum evaporation method, while the atmosphere can be changed from vacuum or an inert gas to a $N_2$—$O_2$ gas mixture in a reactive sputtering method or a reactive vacuum evaporation method, thereby to enable preparation of multi-layer mask blanks according to the same method without taking out the product once into the atmosphere.

The thus prepared photomask blank according to the present invention has a layer structure as shown in Fig. 4a or 4b corresponding to Fig. 3a or 3b.

In order to prepare a photomask as shown in Fig. 3a or 3b from such a photomask blank, a conventional photolithography process or electron beam lithography for patternization of the metal film 7 and the composite film 8 may be used. Thus, a photoresist or an electron beam resist is applied as coating on the composite film of the photomask blank as shown in Fig. 4, then a pattern exposure is effected by ultraviolet rays or an electron beam. This step is then followed by development with a suitable developing agent, and then the exposed composite film 8 and the metal film 7 are subjected to etching. As an etchant for producing chromium masks, a mixed aqueous solution of perchloric acid and ammonium ceric nitrate and other etching solutions in general for chromium etching may be used. Gaseous etchants such as gas mixture of $CCl_4+O_2$ or $Cl_2+Ar+O_2$ may also be used for a dry etching method, especially a plasma etching method, to obtain a similar result.

For the production of tantalum masks, when etching is performed by dry etching with the use of a gas such as $CF_4$ or $CF_4+O_2$, overetching is tolerable to a considerable extent without substantial change in dimensions, whereby there can easily be obtained a photomask with a high precision. Similar effects can also be obtained when using a resist having resistance to hydrofluoric acid or a metallic film as resist and conducting wet etching with the use of an HF type etchant or a hot alkali.

The photomask according to the present invention thus prepared is free from a visor, burr or fracture as described above in the low reflective layer (composite film 8), since the etching speed in the composite film is made equal to that in the metal film by adjustment of the ratio x, y and z in the composite film, and therefore it is a sharp and highly precise mask with excellent durability. Further, the resultant mask can be subjected to ultrasonic washing, scrubber washing with a rotating brush or washing with high pressure water without any change in image quality. Transfer of image onto wafers can also be repeated without damaging the edges of the image.

In order to indicate more fully the nature and utility of this invention, the following examples are set forth, it being understood that these examples are presented as illustrative only and are not intended to limit the scope of the invention.

Example 1

On a soda lime glass substrate, whose surface had been polished to ample smoothness, a chromium layer was first formed to a thickness of 50 nm by sputtering in an inert atmosphere of argon with the use of a chromium target, and then a composite film of chromium oxide and chromium nitride was laminated thereon to a thickness of 30 nm by sputtering with the use of the same argon gas and a composite of chromium oxide and chromium nitride as target, to prepare a one-side low-reflection chromium mask blank.

The first layer chromium film was formed under the conditions of a gas pressure of 1,33 Pa $(1\times10^{-2}$ Torr), a substrate-target distance of 5 cm, and a sputtering speed of 10 nm/min.

The second layer composite film was formed under the conditions of a gas pressure similarly of 1,33 Pa $(1\times10^{-2}$ Torr), a substrate-target distance of 5 cm, a target composition in $Cr_xN_yO_z$ of x:y:z=1:0.3:1.3, and a sputtering speed of 4 nm/min.

The mask blank obtained was made into a photomask according to the well known photolithography process, whereupon there was obtained a very sharp image with minimum line width of 1.0 μm. The photoresist employed in the photolithography process was AZ—1350 (produced by Shipley Co.) with a thickness of 0.5 μm.

The etchant used for etching the chromium film and the composite film had the following composition:

| | |
|---|---|
| $(NH_4)_2Ce(NO_3)_6$: ammonium ceric nitrate | 165 g |
| $HClO_4$: perchloric acid | 43 cc |
| $H_2O$: deionized water | 1,000 cc |

The etching was conducted at 20°C for 40 seconds.

When the thus prepared photomask was subjected to high pressure water washing by means of a plate cleaner (produced by Ultratech Co.), no change in image quality was observed. The water pressure was 13,8 N/mm² (2,000 psi), and washing was continued for 2 minutes.

Example 2

On a quartz glass plate having a well polished surface, a composite film of chromium oxide and chromium nitride was first formed to a thickness of 40 nm by the inert sputtering method with argon gas and a composite of chromium oxide and chromium nitride as target. Then, according to the inert sputtering method, with an argon gas and chromium target, a chromium film was laminated on the composite film to a thickness of 50 nm. This step was followed further by lamination of another composite film of chromium oxide and chromium nitride according to the same method as that used in the first layer to a thickness of 30 nm, thus providing a both-side low-reflection chromium mask blank.

The composite films for the first and the third layers were formed under the conditions of an argon gas pressure of 2,66 Pa $(2\times10^{-2}$ Torr), a substrate-target distance of 5 cm, a sputtering speed of 7 nm/min., and a target composition for $Cr_xN_yO_z$ of x:y:z=1:0.2:1.2.

The chromium film for the second layer was formed under the conditions of an argon gas pressure of 1,07 Pa $(8\times10^{-3})$ Torr, a substrate-target distance of 5 cm, and a sputtering speed of 12 nm/min.

The mask blank thus prepared had a front surface reflectance of 5% for Hg-g line and a backside reflectance of 10% for Hg-e line.

Then according to the same method as in Example 1, a photo-mask having a very sharp image with minimum line width of 0.8 μm was prepared. When ultra-sonic washing at 300 W was applied on this photomask for 10 minutes, and, further, high pressure water washing was applied thereto similarly as in Example 1, nothing abnormal in the image quality was observable, and a precise image could be repeatedly transferred onto wafers.

Example 3

On a synthetic quartz glass substrate, whose surface had been polished to ample smoothness, a tantalum film was formed to a thickness of 60 nm by sputtering under the following conditions:

| | |
|---|---|
| Atmosphere: | Argon (100%) |
| Pressure: | 2,66 Pa ($2\times10^{-2}$ Torr) |
| Substrate-target distance: | 5 cm |
| Sputtering speed: | 10 nm/min. |

Next, on the tantalum film, a composite film composed principally of tantalum nitride and tantalum oxide was formed to a thickness of 25 nm by sputtering under the following conditions:

| | |
|---|---|
| Atmosphere: | Argon (100%) |
| Pressure: | 1,33 Pa ($1\times10^{-2}$ Torr) |
| Substrate-target distance | 5 cm |
| Plasma excitation: | High frequency wave (13.56 MHz) |
| Sputtering speed: | 2,5 nm/min. |
| Sputter target: | Sintered product of $TaO_2/TaN$ (Ta:N:O=1:0.3:1.6) |

The photomask blank thus prepared was found to have a surface reflectance of 5% for Hg-g line and an optical density of 3.0.

Then, according to the well known photolithography process, an AZ—1350 photoresist pattern was formed on the blank. This step was followed by dry etching under the following conditions to obtain a photomask having very sharp image lines with minimum line width of 0.5 μm:

| | |
|---|---|
| Dry etching gas: | $CF_4$ (100%) |
| Pressure: | 1,33 Pa ($10^{-2}$ Torr) |
| Device: | Parallel flat plate counter-electrode type |
| Power density: | 0.3 W/cm² |
| Etching time: | 2 minutes. |

The above dry etching procedure was repeated except for a dry etching time of 15 minutes to obtain the same pattern photomask with difference in dimensions of less than 0.05 μm, as compared with the former one. These photomasks were immersed in a mixture of 100 g of $K_2Cr_2O_7$ and 1,000 ml of $H_2SO_4$ at 80°C for 50 hours. As a result, there was no problem in the characteristics of the photomask with respect to reflectance, optical density and defect. Further, the photomasks could be subjected to scrubber washing with a rotating nylon brush or a highpressure water washing under 13,8 N/mm² (2,000 psi) without any change in image lines.

Example 4

On an LE-30 glass substrate (produced by Hoya Denshi K.K.) having a well polished surface, a composite film composed principally of tantalum oxide and tantalum nitride was formed to a thickness of 40 nm by reactive sputtering under the following conditions:

| | |
|---|---|
| Atmosphere: | Gas mixture of Ar(55%)+He(10%)+ $N_2$(30%)+$O_2$(5%) |
| Pressure: | 2,66 Pa ($2\times10^{-2}$ Torr) |
| Target-mask distance: | 5 cm |
| Sputtering speed | 3 nm/min. |

Next, a tantalum film was formed thereon to a thickness of 50 nm under the same conditions as described in Example 1. Further, as the third layer, a composite film composed principally of tantalum oxide and tantalum nitride was formed again by reactive sputtering to a thickness of 30 nm.

The composition of Ta:N:O (atomic ratio) in the composite film in the resultant photomask blank was found to be 1:0.5:1.7. The blank was found to have a surface reflectance of 7% for Hg-g line, a backside reflectance of 14% for Hg-e line and an optical density of 2.8.

Etching gas:

Device:

Power density:

Etching time:

Comparison was made between the photomasks with various etching times with respect to the dimension of a 1-µm-wide image line. As a result, the difference of dimensions was less than 0.05 µm.

The photomasks as prepared above were subjected to the chemical resistance tests similarly conducted as in Example 3, whereupon it was found that there was substantially no change in mask precision and no increase in defects.

## Claims

1. A photomask blank comprising a transparent substrate (6) and a multi-layer masking film provided on the substrate, said multi-layer masking film comprising a layer (7) of a metal selected from the group consisting of chromium and tantalum and a composite layer (8) of the oxide and nitride of the metal laminated on said metal layer (7).

2. A photomask blank according to claim 1, wherein another composite layer of the oxide and nitride of the metal is interposed between the metal layer and the substrate.

3. A photomask blank according to claim 1 or 2, wherein the metal layer comprises chromium, and the composite layer comprises chromium oxide and chromium nitride in which the atomic ratio of Cr:N:O is in the range of 1:(0.1 to 0.3):(0.8 to 1.4).

4. A photomask blank according to claim 1 or 2, wherein the metal layer comprises tantalum, and the composite layer comprises tantalum oxide and tantalum nitride in which the atomic ratio of Ta:N:O is in the range of 1:(0.15 to 0.5):(1.0 to 2.5).

5. A photomask blank according to any one of claims 1 to 4, wherein the composite layer has been formed by sputtering or vacuum evaporation with the use as source of a sintered product of mixed powders of oxide and nitride of said metal.

6. A photomask blank according to any one of claims 1 to 4, wherein the composite layer has been formed by reactive vacuum evaporation or reactive sputtering with the use of said metal as source in an atmosphere of an $N_2$—$O_2$ gas mixture.

Then, according to the well known photolithography process, an AZ—1350 photoresist pattern was formed on the mask blank. Then dry etching was effected thereon under the following conditions:

Gas mixture of $CF_4$ (100%)+$O_2$(5%)

Parallel flat plate counter-electrode
    type (inter-electrode distance=10 cm)

0.5 W/cm²

2—15 minutes (varied)

7. A photomask blank according to any one of claims 1 to 6, wherein the composite layer has a thickness in the range 20 to 50 nm.

8. A photomask comprising a transparent substrate (6) and a patterned multi-layer masking film provided on the substrate, said patterned multi-layer masking film comprising a layer (7) of a metal selected from the group consisting of chromium and tantalum and a composite layer (8) of the oxide and nitride of the metal laminated on said metal layer (7).

9. A photomask according to claim 8, wherein another composite layer of the oxide and nitride of the metal is interposed between the chromium layer and the substrate as a part of the patternized multi-layer masking film.

10. A photomask according to claim 8 or 9, wherein the metal layer comprises chromium, and the composite layer comprises chromium oxide and chromium nitride in which the atomic ratio of Cr:N:O is in the range of 1:(0.1 to 0.3):(0.8 to 1.4).

11. A photomask according to claim 8 or 9, wherein the metal layer comprises tantalum, and the composite layer comprises tantalum oxide and tantalum nitride in which the atomic ratio of Ta:N:O is in the range of 1:(0.15 to 0.5):(1.0 to 2.5).

12. A photomask according to any one of claims 8 to 11, wherein the multi-layer masking film has been patternized by etching.

## Patentansprüche

1. Fotomaskenplatte mit einem transparenten Substrat (6) und mit einem auf dem Substrat vorgesehenen, mehrschichtigen/abdeckenden Film, wobei der mehrschichtige abdeckende Film eine Schicht (7) aus einem Metall der Chrom und Tantal enthaltenden Gruppe und eine auf die Metallschicht (7) aufgebrachte zusammengesetzte Schicht (8) aus dem Oxid und dem Nitrid des Metalls enthält.

2. Fotomaskenplatte nach Anspruch 1, dadurch gekennzeichnet, daß noch eine zusammengesetzte Schicht aus dem Oxid und dem Nitrid des Metalls zwischen die Metallschicht und das Substrat eingefügt ist.

3. Fotomaskenplatte nach Anspruch 1 oder 2, dadurch gekennzeichnet, daß die Metallschicht Chrom enthält und daß die zusammengesetzte Schicht Chromoxid und Chromnitrid enthält, wobei das Atomverhältnis von Cr:N:O im Bereich von 1:(0,1 bis 0,3):(0,8 bis 1,4) liegt.

4. Fotomaskenplatte nach Anspruch 1 oder 2, dadurch gekennzeichnet, daß die Metallschicht Tantal enthält und daß die zusammengesetzte Schicht Tantaloxid und Tantalnitrid enthält, wobei das Atomverhältnis von Ta:N:O im Bereich von 1:(0,15 bis 0,5):(1,0 bis 2,5) liegt.

5. Fotomaskenplatte nach einem der Ansprüche 1 bis 4, dadurch gekennzeichnet, daß die zusammengesetzte Schicht durch Zerstäuben oder durch Vakuumverdampfen gebildet worden ist, und zwar unter Verwendung eines gesinterten Produktes aus gemischten Pulvern von Oxid und Nitrid des Metalls als Quelle eines gesinterten Produktes.

6. Fotomaskenplatte nach einem der Ansprüche 1 bis 4, dadurch gekennzeichnet, daß die zusammengesetzte Schicht durch reaktionsfähige Vakuumverdampfung oder reaktionsfähige Zerstäubung unter Verwendung des Metalls als Quelle in einer Atmosphäre einer $N_2$—$O_2$—Gasmischung gebildet worden ist.

7. Fotomaskenplatte nach einem der Ansprüche 1 bis 6, dadurch gekennzeichnet, daß die zusammengesetzte Schicht eine Dicke im Bereich von 20 bis 50 nm besitzt.

8. Fotomaske, bestehend aus einem transparenten Substrat (6) und aus einem mit einem Muster versehenen, mehrschichtigen abdeckenden Film auf dem Substrat, wobei der mit einem Muster versehene Film eine Schicht (7) aus einem Metall, das aus der Chrom und Tantal enthaltenden Gruppe ausgewählt ist, und eine auf die Metallschicht (7) aufgebrachte zusammengesetzte Schicht (8) aus dem Oxid und dem Nitrid des Metalls enthält.

9. Fotomaske nach Anspruch 8, dadurch gekennzeichnet, daß noch eine zusammengesetzte Schicht aus dem Oxid und dem Nitrid des Metalls zwischen die Chromschicht und das Substrat als ein Teil des mit einem Muster versehenen, mehrschichtigen, abdeckenden Films eingefügt ist.

10. Fotomaske nach Anspruch 8 oder 9, dadurch gekennzeichnet, daß die Metallschicht Chrom enthält und daß die zusammengesetzte Schicht Chromoxid und Chromnitrid enthält, wobei das Atomverhältnis von Cr:N:O im Bereich von 1:(0,1 bis 0,3):(0,8 bis 1,4) liegt.

11. Fotomaske nach Anspruch 8 oder 9, dadurch gekennzeichnet, daß die Metallschicht Tantal enthält und daß die zusammengesetzte Schicht Tantaloxid und Tantalnitrid enthält, wobei das Atomverhältnis von Ta:N:O im Bereich von 1:(0,15 bis 0,5):(1,0 bis 2,5) liegt.

12. Fotomaske nach einem der Ansprüche 8 bis 11, dadurch gekennzeichnet, daß der mehrschichtige, abdeckende Film durch Ätzen mit einem Muster versehen worden ist.

## Revendications

1. Une plaque pour masque photographique comprenant un substrat transparent (6) et un film masquant multicouche placé sur le substrat, ledit film masquant multicouche comprenant une couche (7) d'un métal choisi parmi le chrome et le tantale et une couche composite (8) de l'oxyde et du nitrure du métal stratifiée sur ladite couche métallique (7).

2. Une plaque pour masque photographique selon la revendication 1, dans laquelle une autre couche composite de l'oxyde et du nitrure du métal est intercalée entre la couche métallique et le substrat.

3. Une plaque pour masque photographique selon la revendication 1 ou 2, dans laquelle la couche métallique consiste en chrome et la couche composite consiste en oxyde de chrome et nitrure de chrome dans des proportions atomiques Cr:N:O dans la gamme de 1:(0,1 à 0,3):(0,8 à 1,4).

4. Une plaque pour masque photographique selon la revendication 1 ou 2, dans laquelle la couche métallique consiste en tantale et la couche composite consiste en oxyde de tantale et nitrure de tantale dans les proportions atomiques Ta:N:O dans la gamme de 1:(0,15 à 0,5):(1,0 à 2,5).

5. Une plaque pour masque photographique selon l'une quelconque des revendications 1 à 4, dans laquelle la couche composite a été formé par pulvérisation ou évaporation sous vide avec l'utilisation comme source d'un produit fritté de poudres mélangées d'oxyde et de nitrure dudit métal.

6. Une plaque pour masque photographique selon l'une quelconque des revendications 1 à 4, dans laquelle la couche composite a été formée par évaporation réactive sous vide ou pulvérisation réactive avec utilisation dudit métal comme source dans une atmosphère d'un mélange gazeux $N_2$—$O_2$.

7. Une plaque pour masque photographique selon l'une quelconque des revendications 1 à 6, dans laquelle la couche composite a une épaisseur dans la gamme de 20 à 50 nm.

8. Un masque photographique consistant en un substrat transparent (6) et un film masquant multicouche avec image sur le substrat, ledit film masquant multicouche avec image consistant en une couche (7) d'un métal chosi parmi le chrome et le tantale et une couche composite (8) de l'oxyde et du nitrure du métal stratifiée sur ladite couche métallique (7).

9. Un masque photographique selon la revendication 8, dans lequel une autre couche composite de l'oxyde et du nitrure du métal est intercalée entre la couche de chrome et le substrat comme partie du film masquant multicouche avec image.

10. Un masque photographique selon la revendication 8 ou 9, dans lequel la couche métallique consiste en chrome et la couche composite consiste en oxyde de chrome et nitrure de chrome dans les proportions atomiques Cr:N:O dans la gamme de 1:(0,1 à 0,3):(0,8 à 1,4).

11. Un masque photographique selon la revendication 8 ou 9, dans lequel la couche métallique consiste en tantale et la couche composite consiste en oxyde de tantale et nitrure de tantale dans les proportions atomiques Ta:N:O dans la gamme de 1:(0,15 à 0,5):(1,0 à 2,5).

12. Un masque photographique selon l'une quelconque des revendications 8 à 11, dans lequel le film masquant multicouche a été soumis à la formation d'images par attaque.

# F I G. 1
## PRIOR ART

### (a)

### (b)

# F I G. 2
## PRIOR ART

# F I G. 3

### (a)

### (b)

# F I G. 4

### (a)

### (b)